# EUROPEAN PATENT APPLICATION

(11) **EP 4 518 592 A1**
(43) Date of publication of application: **05.03.2025**
(21) Application number: 23306446.8
(22) Date of filing: 31.08.2023
(51) Int. Cl.: H05K 7/14, H05K 7/20

(54) **MODULAR DATACENTER FOR IMMERSIVE COOLING SYSTEMS**

(71) Applicant: OVH, 59100 Roubaix (FR)
(72) Inventor: CHEHADE, Ali, 59283 Moncheaux (FR); KLABA, Henryk, 59100 Roubaix (FR); HNAYNO, Mohamad, 59100 Roubaix (FR)
(74) Representative: BCF Global

(57) **Abstract**

A modular datacenter is disclosed. The modular datacenter includes a containment unit, a first rack system mounted in the containment unit and extending along a first side wall thereof, a second rack system mounted in the containment unit and extending along a second side wall thereof. The second wall is opposed to the first wall, the first and second rack systems being spaced from one another and defining an aisle there between. The first and second rack systems are configured to house electronic devices disposed in immersion casings filled with an immersion cooling liquid. The modular datacenter further includes an extraction mobile apparatus for performing maintenance on the electronic devices, the extraction mobile apparatus being operatively connected to a floor surface of the containment unit and configured to navigate along the aisle.

## Description

### FIELD OF TECHNOLOGY

The present technology relates to overall datacenter configurations, and in particular, to a modular datacenter configuration for immersive cooling systems.

### BACKGROUND

In efforts to process vast amounts of data in near-real time, permanent datacenters house and service multitudes of racks containing electronic equipment, such as, computer server assemblies, specialized processors, memory components, high-speed network modules, *etc.* as well as supporting infrastructure equipment, such as, power facilities, air handling systems, liquid cooling structures, *etc.*

Datacenters and other large computing facilities may contain thousands of racks supporting thousands or even tens of thousands of servers. As the servers and other electronic equipment generate significant amounts of heat, ensuring adequate cooling of the electronic equipment stored in the racks is an important consideration. Notably, the performance of the electronic equipment can be compromised by excess heat, in some cases even leading to failure. Immersion cooling (sometimes called immersive cooling) is a recently introduced solution for cooling electronic devices such as servers. It consists in storing the servers in immersion tanks (also referred to as "immersion racks" given that they replace the conventional racks used in datacenters) that are fully or partially filled with an immersion cooling liquid. In this manner, good thermal contact is obtained between the electronic devices and the cooling medium, namely the dielectric cooling liquid.

However, a situation may exist in which certain space-limited geographical areas having high data processing needs (*e.g*., urban areas, research campuses, *etc*.), may not be able to accommodate sprawling modular datacenter configurations. It may, therefore, be desirable to provide modular datacenter configurations having smaller footprints and using immersive cooling systems.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

It is an object of the present technology to ameliorate at least some of the inconveniences of the prior art.

In a first broad aspect of the present technology, there is provided a modular datacenter including a containment unit having a first side wall extending along a longitudinal axis of the containment unit and a second side wall, opposite the first side wall, extending along the longitudinal axis of the containment unit, a rack system mounted in the containment unit and extending along the first side wall, the rack system being configured to house electronic devices disposed in immersion casings filled with immersion cooling liquid, and an extraction mobile apparatus for performing maintenance on the electronic devices. The extraction mobile apparatus includes displacing means, a support arrangement for receiving at least one of the immersion casings, and a body extending from the displacing means to the support arrangement. The extraction mobile apparatus is configured to navigate along the rack system.

Broadly speaking, the extraction mobile apparatus may help in manipulating the electronic devices in relatively exiguous spaces that comes with modular datacenter configurations having smaller footprints, and notably immersively cooled electronic devices for which immersive cooling liquid must not be spilled. The extraction mobile apparatus may thus help in preserving physical integrity of human operators. Therefore, the extraction mobile apparatus may perform maintenance actions in a more suitable manner with respect to a human operator in the context of modular datacenters.

In some non-limiting implementations, the extraction mobile apparatus is further configured to align the support arrangement longitudinally and vertically in front of the at least one immersion casings when the at least one immersion casings is located in the rack system.

In some non-limiting implementations, the extraction mobile apparatus is further configured to extract the at least one immersion casings from the rack system.

In some non-limiting implementations, is further configured to displace the at least one immersion casing to a maintenance area.

In some non-limiting implementations, the containment unit further comprises an operation platform in the maintenance area for receiving the at least one immersion casing.

In some non-limiting implementations, the modular datacenter further includes a second rack system mounted in the containment unit and extending along a second side wall thereof, the second wall being opposed to the first wall, the first and second rack systems being spaced from one another and defining an aisle there between, the first and second rack systems being configured to house electronic devices disposed in immersion casings filled with an immersion cooling liquid. The extraction mobile apparatus is configured to navigate along the aisle, and extract at least one of the immersion casings from any one of the first and second rack systems.

In some non-limiting implementations, the modular datacenter further includes a cooling loop for cooling the electronic devices, the cooling loop comprising cooling liquid units in thermal contact with the electronic devices for transferring thermal energy generated by the electronic devices to a channelized cooling liquid flowing in the cooling loop and a liquid cooling module for cooling the channelized cooling liquid.

In some non-limiting implementations, the modular datacenter further includes an air-to-liquid heat exchanger mounted on a top surface of the containment unit and configured to cool the channelized cooling liquid by discharging thermal energy thereof into a vicinity of an outside of the containment unit.

In some non-limiting implementations, the air-to-liquid heat exchanger includes at least one fan rotatable about a respective rotation axis and configured to pull ambient air into the air-to-liquid heat exchanger, the rotation axis extending substantially horizontally and parallel to the top surface of the containment unit.

In some non-limiting implementations, the air-to-liquid heat exchanger includes a heat exchanger panel defining a cooling coil for circulating the channelized cooling liquid therein, the heat exchanger panel extending substantially vertically and orthogonally to the top surface of the containment unit.

In some non-limiting implementations, the modular datacenter further includes an air cooling module for cooling air within the containment unit.

In some non-limiting implementations, the modular datacenter further includes electronic switches electrically coupled to the electronic devices, the electronic switches being fixedly attached to a ceiling surface of the containment unit.

In some non-limiting implementations, the electronic devices are servers.

In some non-limiting implementations, the containment unit is a shipping container.

In a second broad aspect of the present technology, there is provided a method for operating an extraction mobile apparatus in a modular datacenter. The method includes positioning the extraction mobile apparatus in front of a rack column of a rack system within a containment unit of the modular datacenter, the rack system being configured to house electronic devices disposed in immersion casings filled with immersion cooling liquid, positioning a support arrangement of the extraction mobile apparatus in front of a given rack shelf of the rack column, actuating a support arrangement for extracting at least one of the immersion casings from the rack system and actuating displacing means of the extraction mobile apparatus to move the extraction mobile apparatus towards a maintenance area and causing the extraction mobile apparatus to dispose the at least one of the immersion casings in the maintenance area.

In some non-limiting implementations, the maintenance area is defined within the containment unit of the modular datacenter.

In a third broad aspect of the present technology, there is provided a extraction mobile apparatus including a chassis, an elongated body extending substantially vertically from the chassis, a support arrangement movably mounted to the elongated body, displacing means operably connected to the chassis for displacing the extraction mobile apparatus along a rack system, the rack system comprising rack-mounted assemblies and a controller communicably connected to the displacing means and the support arrangement. The controller is configured to receive instructions to extract a target rack-mounted assembly, cause the extraction mobile apparatus to navigate along the rack system, cause an adjustment of a height of the support arrangement relatively to the target rack-mounted assembly to be extracted and cause the support arrangement to extract the target rack-mounted assembly.

In some non-limiting implementations, the displacing means are operably connected to a ground surface of a containment unit, the rack system being disposed along a longitudinal side wall of the containment unit.

In some non-limiting implementations, the containment unit further comprises a second rack system mounted therein and extending along a second side wall thereof, the second wall being opposed to the first wall, the first and second rack systems being spaced from one another and defining an aisle there between, the first and second rack systems being configured to house the rack-mounted assemblies, the elongated body is pivotably connected to the displacing means. The extraction mobile apparatus is configured to navigate along the aisle, and extract at least one of the immersion casings from any one of the first and second rack systems by rotating the elongated body.

In some non-limiting implementations, the containment unit is a shipping container.

In some non-limiting implementations, the extraction mobile apparatus further includes a sensor communicably connected to the controller, the controller being configured to identify the target rack-mounted assembly based on the instructions and data provided by the sensor.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
Figure 1 is a perspective view of a modular datacenter according to non-limiting implementations of the present technology;
Figure 2 is a top view of an air-to-liquid heat exchanger of the modular datacenter of Figure 1;
Figure 3 is a perspective view of a containment unit of the modular datacenter of Figure 1;
Figure 4 is a perspective view of a first side of a cross section of the containment unit of Figure 3;
Figure 5 is a perspective view of a second side of a cross section of the containment unit of Figure 3;
Figure 6 is a perspective view of a rack system for housing numerous electronic devices according to non-limiting implementations of the present technology;
Figure 7 is a perspective view of a rack-mounted assembly containing one of the electronic devices according to non-limiting implementations of the present technology;
Figure 8 shows a perspective view of an extraction mobile apparatus according to non-limiting implementations of the present technology;
Figure 9 is a perspective view of a displacing mechanism of the extraction mobile apparatus of Figure 8;
Figure 10 is a perspective view of a support arrangement of the extraction mobile apparatus of Figure 8 upon extraction of a rack-mounted assembly from a corresponding rack system;
Figure 11 is a perspective view of a locking mechanism of the support arrangement of Figure 10;
Figure 12 is a perspective view of the support arrangement of Figure 10 once the rack-mounted assembly has been extracted from the corresponding rack system; and

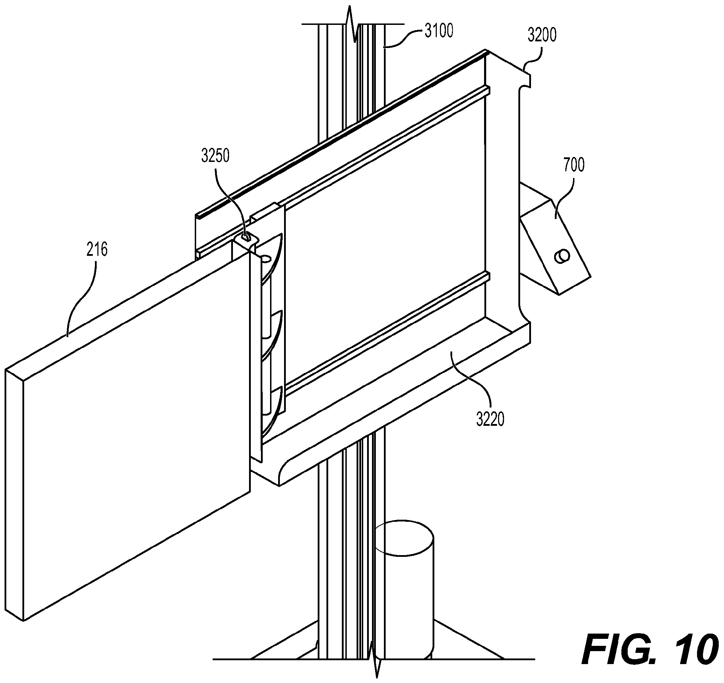

Figure 10 is a block diagram of a controller according to non-limiting implementations of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

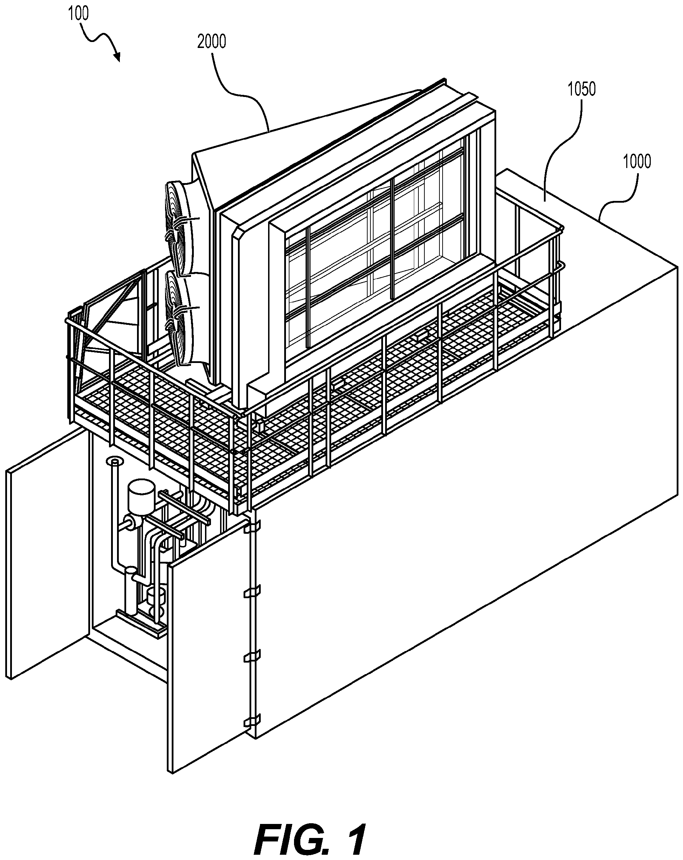

Figure 1 is a perspective view of a modular datacenter 100 including a containment unit 1000 and an air-to-liquid heat exchanger 2000 mounted on a top surface 1050 thereof. The containment unit 1000 may be embodied by trailers, shipping containers, or other similarly-configured structures. In use, the containment unit 1100 houses and services an assembly of multiple racks containing electronic equipment, such as, computer server assemblies, specialized processors, memory components, high-speed network modules, along with supporting infrastructure equipment, such as, power facilities, air handling systems, liquid cooling structures, *etc.* It will be appreciated that each of the containment unit 1000 may incorporate different components and equipment of an overall modular datacenter system. The containment unit 1000 may incorporate one or more openings (not shown) to enable ventilation of the data processing equipment as well as accommodate the routing of associated cabling and/or piping arrangements to another containment unit and/or to external resources.

As will be described in greater details herein after, the containment unit 1000 houses electronic devices such as servers that may generate a significant amount of heat. Consequently, the modular datacenter 100 may use a cooling system to cool down the electronic devices to prevent the electronic devices from being damaged. In this implementation, the cooling system of the modular datacenter 100 is a hybrid cooling system including an immersion cooling system and a channelized cooling system.

As used herein, an immersion cooling system is a cooling system in which the electronic device is in direct contact with a cooling liquid (e.g. a non-conductive cooling liquid), which either flows over at least portions of the electronic device, or in which at least portions of the electronic device are submerged. As used herein, a channelized cooling system is a cooling system in which heat-generating components of the electronic device (i.e. electronic components thereof) or the dielectric cooling liquid are cooled using liquid cooling units, through which a channelized cooling liquid flow to collect thermal energy, which may also be called "cold plates" or "water blocks" (although the channelized cooling liquid circulating through the "water blocks" may be any of a wide variety of known thermal transfer liquids, rather than water). The channelized cooling liquid may be further cooled down using an air-to-liquid heat exchanger such as the air-to-liquid heat exchanger 2000. While in this example the channelized cooling liquid flowing in the closed loop may be water, the channelized cooling liquid may be a dielectric fluid, a refrigerant fluid, a diphasic fluid or any other fluid suitable for collecting and discharging thermal energy.

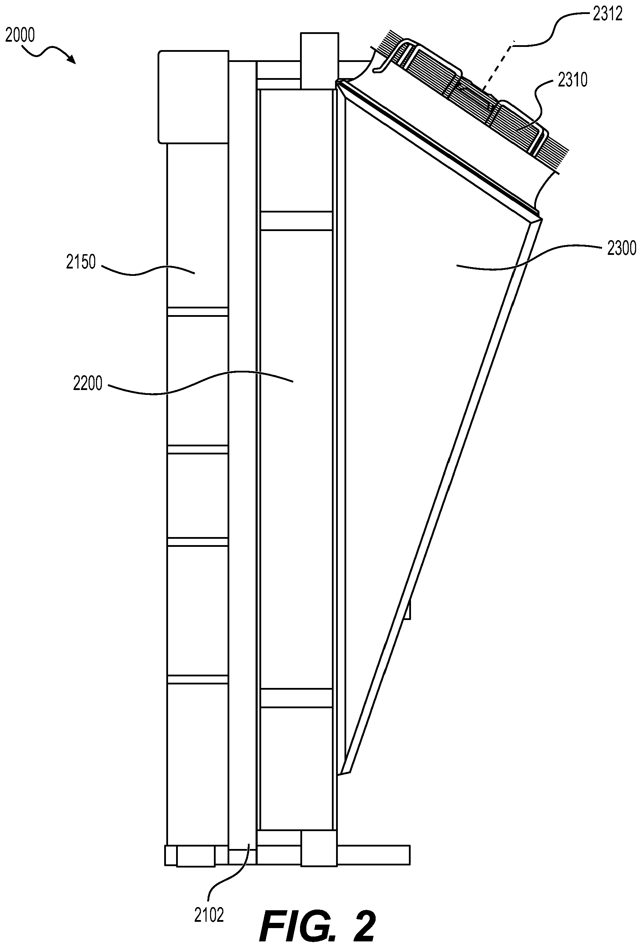

As shown on Figure 1 and with additional reference to Figure 2, the air-to-liquid heat exchanger 2000 extends substantially orthogonally to the top surface 1050 of the containment unit 1000. More specifically, the air-to-liquid heat exchanger 2000 includes a heat exchanger panel 2200 for discharging thermal energy of the channelized cooling liquid into the atmosphere. In particular, the heat exchanger panel 2200 is a liquid-to-air heat exchanger panel 2200 that transfers thermal energy from the channelized cooling liquid circulating therein to the air flowing there through. More specifically, the heat exchanger panel 2200 may have an air inlet side and an air outlet side through which, in use, air enters and exits the heat exchanger panel 2200 respectively.

The heat exchanger panel 2200 may include a cooling coil (not shown) for circulating the channelized cooling liquid therein and a plurality of fins (not shown) in thermal contact with the cooling coil. The cooling coil has an inlet and an outlet, as depicted in Figure 1, for feeding the channelized cooling liquid into and discharging the heat transfer fluid from the cooling coil. The fins may be spaced from one another for air to flow there between, from the air inlet side to the air outlet side of the heat exchanger panel 2200.

It is contemplated that the air-to-liquid heat exchanger 2000 may optionally include at least one cooling pad 2100, or evaporating pad, disposed on an exterior face of the heat exchanger 2000. With reference to Figure 2, the cooling pad 2100 is disposed on a lateral side of the heat exchanger 2000. A cooling fluid may be dispensed across the cooling pad 2100, providing a cool surface. The ambient air is pulled through the cool surface of the cooling pad 2100, thereby cooling the ambient air prior to contact with the heat exchanger panel 2200. In use, the cooling fluid may be sprayed on the cooling pad 2100. The cooling fluid may be water, possibly with additives such as polyethylene glycol (PEG) and/or polypropylene glycol (PPG).

A distribution system may distribute the second cooling fluid in a surrounding environment of the air-to-liquid heat exchanger 2000, notably, in this example, onto the cooling pad 2100, such that ambient air flows through the wet cooling pad 2100. Temperature of ambient air flowing through the cooling pad 2100 thus decreases as a portion of the second cooling fluid (e.g. water droplets) distributed on the cooling pad 2100 evaporates. Thermal energy of the ambient air is thus absorbed by evaporation of the portion of the second cooling fluid such that the air flow's temperature is reduced. The cooling pad 2100 may be made of plastic material, cellulose, or glass fibers, but other materials are also contemplated in alternative embodiments.

The heat exchanger 2000 comprises a fan assembly 2300 that, in use, causes airflow through the heat exchanger 2000. In particular, the fan assembly 2300 comprises a plurality of fans 2310 (only one can be seen on Figure 2). In this example, the fans 142 are rotatable about respective horizontal axes 2312 to pull ambient air into the air-to-liquid heat exchanger panel 2200. In this implementation, the rotation axis 2312 extends substantially horizontally, parallel to the top surface 1050 of the containment unit 1000, and at an angle with respect to a normal of the heat exchanger panel 2200. For example, said angle may be between 45° and 90°.

The heat exchanger 2000 thus functions by pumping heated channelized cooling liquid extracted from the electronic devices through the cooling coils of the heat exchanger panel 2200, while simultaneously pulling ambient air between the fins and around the cooling coil of the heat exchanger panel 2200. The ambient air absorbs heat from the heated channelized cooling liquid circulating through the cooling coils. As ambient air is pulled in through the heat exchanger panel 2200 into an interior space of the heat exchanger 2000, thermal energy is transferred from the channelized cooling liquid circulating in the heat exchanger panel 2200 to the ambient air. The now-heated air is then discharged from the interior space of the heat exchanger 2000 through the fan assembly 2300. The channelized cooling liquid circulating in the heat exchanger panel 2200 is thus cooled and is recirculated back into the cooling loop to further collect thermal energy from the electronic devices for cooling thereof.

It will be appreciated that the configuration of the heat exchanger 2000 as described above is provided merely as an example to aid in understanding the present technology. The heat exchanger 2000 may be configured differently in other examples. For instance, a plurality of heat exchanger panels 20 may be provided, and the fan assembly 2300 may include a single fan 2310.

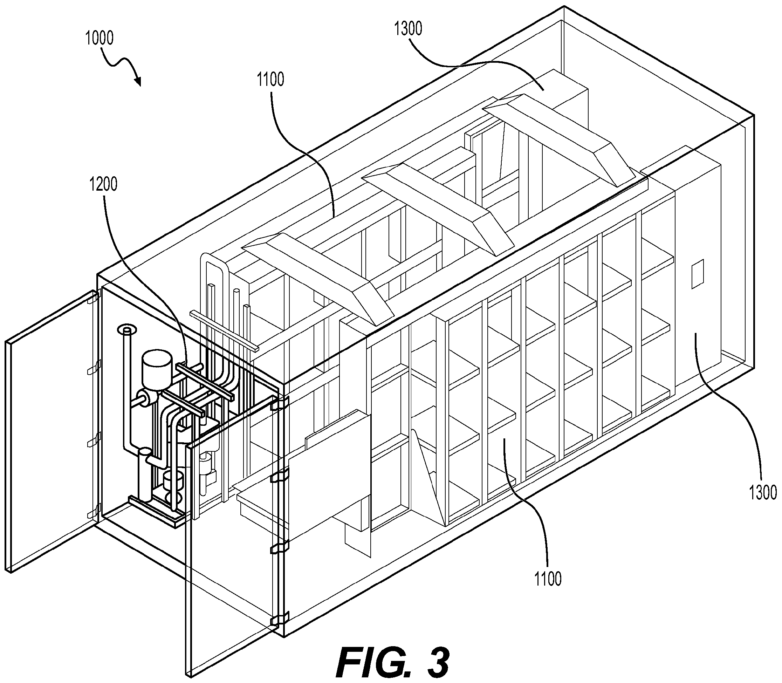

As shown on Figure 1 and with additional reference to Figures 3 to 5, the containment unit 1000 includes two rack systems 1100, a cooling module 1200 and electrical cabinets 1300 that are arranged to form an aisle 1400 substantially centered in the containment unit 1000 and extending along a length thereof. A non-slip honeycomb mat may be disposed along the aisle 1400, and a tank or circulation grooves that may receive any potential spillage of liquid (e.g. oil, cooling liquid, etc.) through the mat.

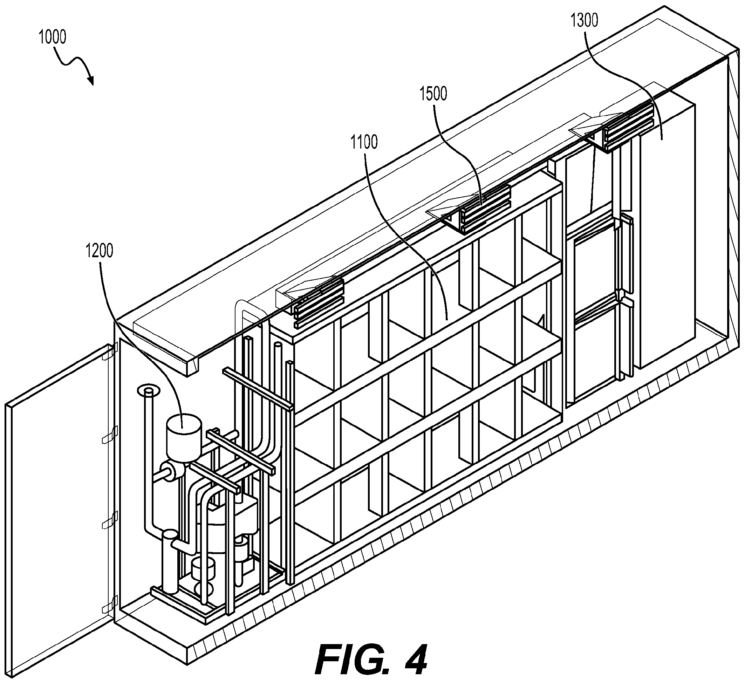

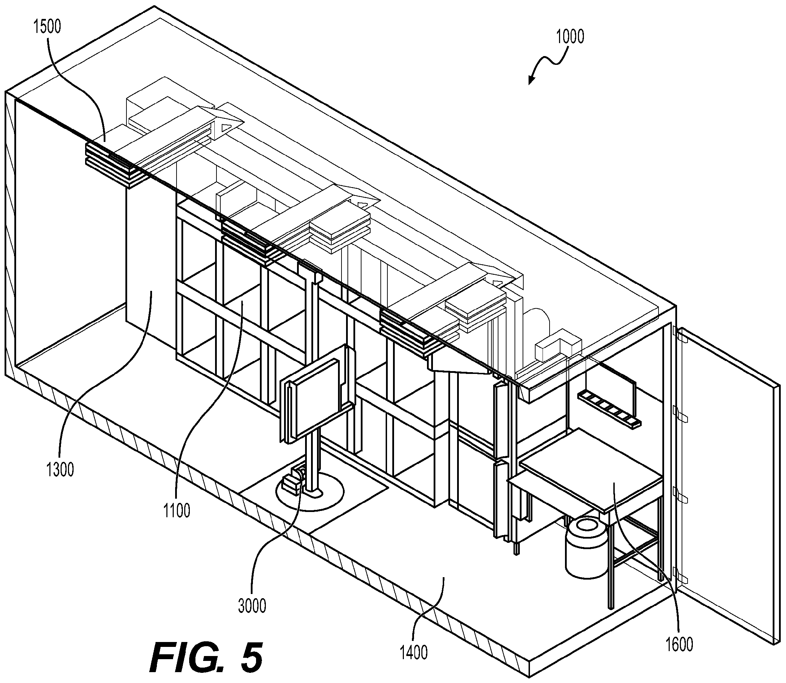

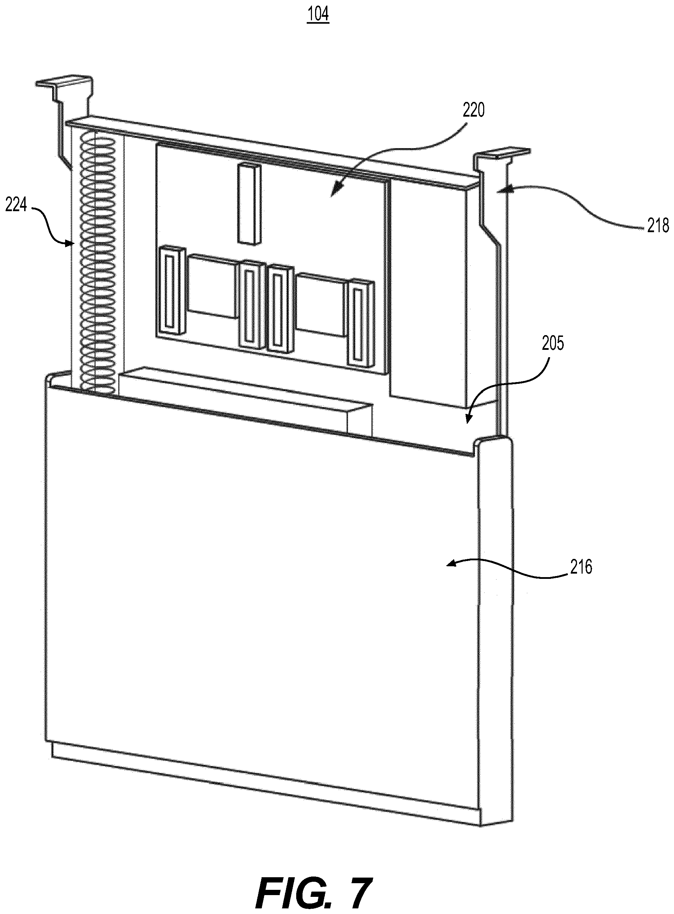

In some implementations, the containment unit 1000 further includes, as best shown on Figures 4 and 5, electronic switches 1500 electrically coupled to the electronic devices 220 (see Figure 7), the electronic switches 1500 being fixedly attached to a ceiling surface of the containment unit. This may optimize a usage of the interior space of the containment unit 1000. The containment unit 100 may include a false floor and/or a false ceiling configured to host electric wires for electrical connectivity between electrical and electronic devices of the modular datacenter 10 and/or piping for circulating cooling liquids.

The cooling module 1200 may include pumps, piping assemblies, temperature sensors, liquid flow rate sensors, controllers and other data processing system for automation of the cooling of the electronic devices 220.

In some implementations, each of the electrical cabinets 1300 may include routers, electrical power distribution units, power equipment, networking devices, fuses, sensors, data collecting devices, or any other suitable electrical components involved in proper operation of the modular datacenter 100.

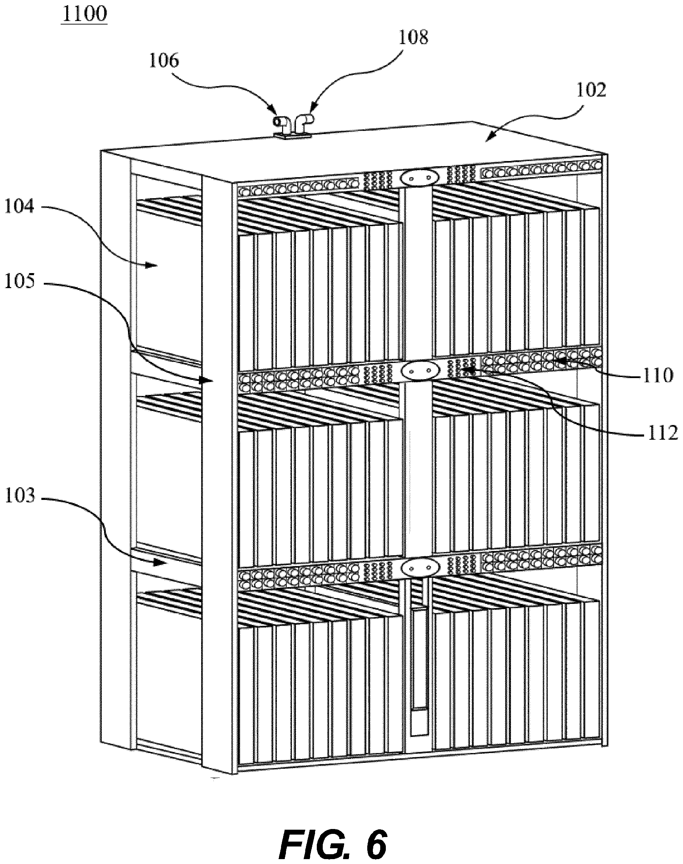

Figure 6 shows a rack system 1100 according to some implementations of the present technology. In use, the rack system 1100 for housing numerous rack-mounted assemblies 104 including the electronic devices for providing immersive cooling to said electronic devices, in accordance with the embodiments of the present disclosure. As shown, the rack system 1100 may include a rack frame 102, rack-mounted assemblies 104, a liquid cooling inlet conduit 106 and a liquid cooling outlet conduit 108. The rack-mounted assemblies 104 may be oriented vertically with respect to the rack frame 102, resembling books on a library shelf. This arrangement may provide for mounting a large number of such rack-mounted assemblies 104 in the rack frame 102, relative to conventional arrangements, particularly with respect to conventional arrangements of immersion-cooled rack-mounted assemblies.

Additionally, as shown, the rack system 1100 may further comprise a power distribution unit (PDU) 110 and liquid coolant inlet/outlet connectors 112. It is to be noted that the rack system 1100 may include other components such as heat exchangers, cables, pumps or the like, however, such components have been omitted from Figure 6 for clarity of understanding. As shown in Figure 6, the rack frame 102 may include rack shelves 103 to accommodate one or more rack-mounted assemblies 104. As noted above, the one or more rack-mounted assemblies 104 may be arranged vertically with respect to the rack shelves 103. In some embodiments, guide members (not shown) may be used on the rack shelves 103 to guide the rack-mounted assemblies 104 into position during racking and de-racking, and to provide proper spacing between the rack-mounted assemblies 104 for racking and de-racking. As further shown in Figure 6, the rack frame 102 may also include rack posts 105 to support the rack shelves 103.

Figure 7 shows a perspective view of a rack-mounted assembly 104 in accordance with the implementations of the present disclosure. As shown, the rack-mounted assembly 104 includes a detachable frame, or "board" 218 onto which the electronic device 220 (e.g. server) is mounted, and an immersion case 216 wherein the board is inserted. The board 218 holds heat-generating electronic components 222 of the electronic device 220 and may be immersed in the immersion cooling liquid within the immersion case 216. Examples of heat-generating components include, but are not limited to, central processing units (CPUs), graphics processing units (GPUs), neural processing units (NPUs), tensor processing units (TPUs), power supply circuitry, and application-specific integrated circuits (ASICs), including, for example, ASICs configured for high-speed cryptocurrency mining.

Although, the immersion case 216, board 218, and electronic components 222 are shown as separate parts, it will be understood by one of ordinary skill in the art that, in some implementations, two or more of these components could be combined. For example, the electronic components 222 could be fixed directly on the board 218 and/or the immersion case 216.

It is contemplated that the electronic devices 220 may generate a significant amount of heat. Consequently, the rack system 1100 may use a cooling system to cool down the electronic devices 220 to prevent the electronic devices 220 from being damaged. In this implementation, the cooling system of the rack-mounted assembly 104 is a hybrid cooling system including an immersion cooling system and a channelized cooling system.

In this implementation, the immersion case 216 may contain an immersive cooling liquid. Further, the board 218 including the electronic components 222 may be submerged at least in part in the immersion cooling case 216. In some implementations, the immersive cooling liquid and the board 218 may be inserted into the immersion case 216 via an opening 205 at the top of the immersion case 216. In some implementations, the opening 205 may remain at least partially open during operation of the electronic device 220, providing a non-sealed configuration for the immersion case 216. Such non-sealed configurations may be easier to manufacture and maintain than sealed configurations, but may be inappropriate for, *e.g*., two-phase systems, in which the immersion cooling liquid may boil during operation of the electronic device 220.

In this implementation, a channelized cooling system us further used to cool the immersion cooling liquid and/or the electronic device 220. For example, liquid cooling units, which may also be called "cold plates" or "water blocks", and/or a convection-inducing structure, such as a serpentine convection coil 124, in which a flow of the channelized cooling liquid (e.g. water) is maintained may be used to cool the immersion cooling liquid and/or the electronic device 220. The channelized cooling liquid is further cooled by the air-to-liquid heat exchanger 2000 as described hereinbefore before being redirected back to the rack-mounted assembly 104, thereby forming a cooling loop.

As best shown on Figures 3 to 5, the modular datacenter 100 includes a first rack system 1100 mounted in the containment unit 1000 and extending along a first side wall thereof, and a second rack system mounted in the containment unit 1000 and extending along a second side wall thereof, the second wall being opposed to the first wall. In this implementation, the first and second side walls extend along a length of the containment unit 1000. The first and second rack systems 1100 are spaced from one another to define an aisle 1400 (see Figure 5) there between.

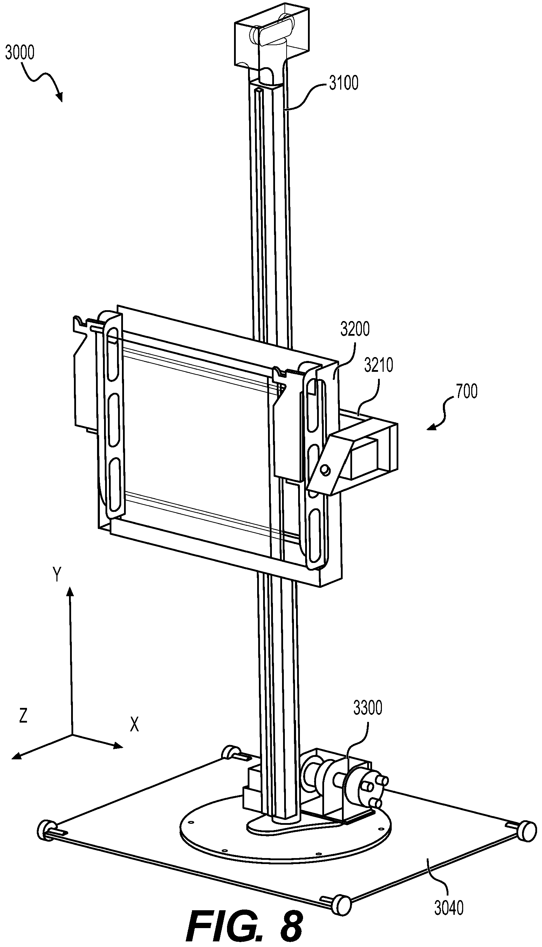

With reference to Figures 5 and 8, the containment unit 1000 further includes an extraction mobile apparatus 3000 that, in use, performs maintenance on the rack-mounted assemblies 104. In the context of the present disclosure, maintenance includes, without being limited to, inserting the rack-mounted assemblies 104 in the rack system 1100, extracting the rack-mounted assemblies 104 therefrom, displacing the rack-mounted assemblies 104, and disconnecting and connecting the rack-mounted assemblies 104 from an electric power source. In use, the extraction mobile apparatus 3000 is configured to navigate along any one of the rack systems 1100. It should be noted that the rack-mounted assemblies 104 may be relatively heavy to be carried by a human operator, whose physical integrity must be preserved. Moreover, the rack-mounted assemblies 104 contains sensitive and costly components, as well as immersive cooling liquid which must not be spilled. Therefore, the extraction mobile apparatus 3000 may perform these actions in a more suitable manner with respect to a human operator.

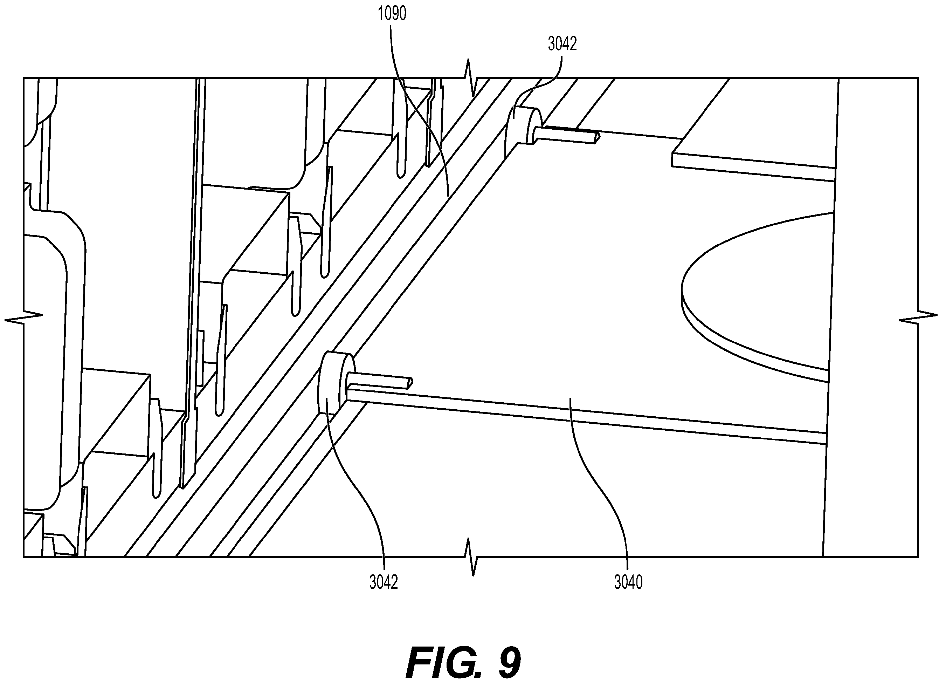

To do so, the extraction mobile apparatus 3000 includes displacing means 3042 to navigate along the aisle 1400. For example, the displacing elements 3042 may include wheels, endless tracks and/or a mechanism for travelling on rails fixedly attached to the containment unit 1000 along the aisle 1400. In this implementation and as best shown on Figure 9, the extraction mobile apparatus 3000 includes a support surface, or chassis, 3040 onto which the displacing means 3042 are mounted. In this implementation, the displacing means 3042 are wheels that engage in rails 1090 affixed to a ground surface of the containment unit 1000.

Referring back to Figure 8, the extraction mobile apparatus 3000 includes a body having an elongated shape. The body may thus be referred to as a pole 3100 extending substantially vertically from the chassis 3040. A support arrangement 3200 for receiving at least one of the rack-mounted assemblies 104 or the immersion casings 216 is slidably connected to the pole 3100 (along a direction of the aisle 1400 i.e. the Y axis). In use, the support arrangement 3200 may thus slide (e.g. using a motor 3300 mounted to the pole 3100 or to the chassis 3040) along the pole 3100 to adjust a height of the support arrangement 3200. In some other implementations, the pole 3100 is telescopic such that the height of the support arrangement 3200 may be adjusted by actuation of telescopic pole 3100.

In this implementation, the support arrangement 3200 is connected to the pole 3100 via a mechanical arm 3210 that may translate the support arrangement 3200 along an horizontal direction. As depicted on Figure 8, the support arrangement 3200 may be translated along an horizontal direction that is perpendicular to the aisle 1400 (i.e. along the X axis). In addition, the pole 3100 is pivotably connected to the chassis 3040 and may be rotated around the vertical axis by the motor 3300 (i.e. the Y axis), such that support arrangement 3200 may be further translated along any horizontal direction orthogonally to the vertical axis. Therefore, the support arrangement 3200 may be brought close to or in contact with any rack-mounted assembly 104 through vertical displacement along the pole 3100, rotation thereof and horizontal displacement provided by the mechanical arm 3210. Once the support arrangement 3200 is brought into contact with a given rack-mounted assembly 104, the support arrangement 3200 may extract said rack-mounted assembly 104 from a corresponding rack system 100 for maintenance thereof.

Figure 10 shows the support arrangement 3200 upon extraction of a rack-mounted assembly from a corresponding rack system. Only the casing 216 of the rack-mounted assembly is depicted on Figure 10 for simplicity thereof. In this implementation, the support arrangement 3200 is brought in contact with the casing 216 (e.g. via actuation of the mechanical arm 3210). A locking mechanism 3250 movably mounted to the support arrangement 3200 further connects the casing 216 to the support arrangement 3200.

More specifically, the support arrangement 3200 includes a supporting plate 3220 substantially extending along a horizontal plane for supporting the casing 216 once extracted. The support arrangement 3200 also includes a guiding plate 3230 extending perpendicularly to the supporting plate 3220. In this implementation, the locking mechanism 3250 is slidably connected to rails mounted on the guiding plate 3230. In use, a position of the locking mechanism 3250 along the rail may be controlled by a controller and/or a command module.

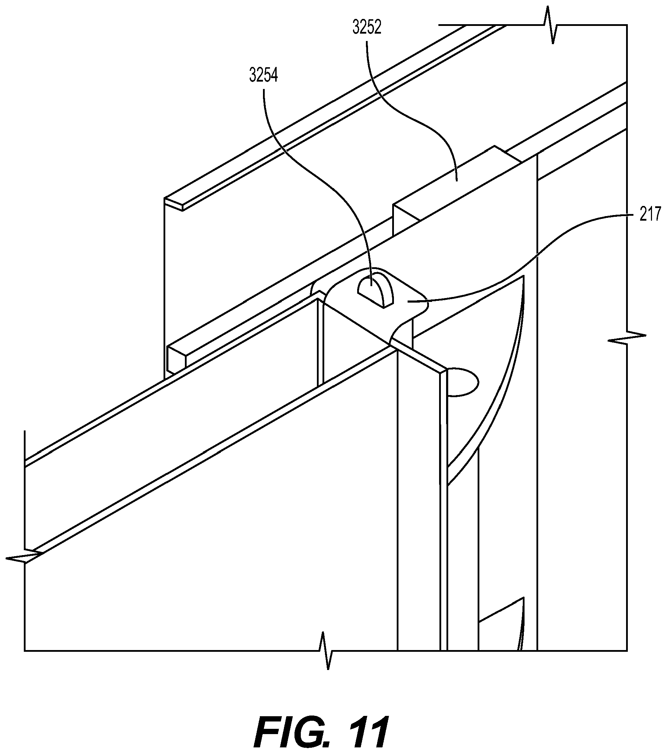

As best shown in Figure 11, the locking mechanism 3250 include a sliding element 3252 slidably connected to the rail and a tab 3254 connected to the sliding element 3252. The tab 3254 extends substantially vertically and is configured to engage with a casing tab 217 extending from the casing 216. In this implementation, the casing tab 217 extends substantially horizontally and defines an opening for receiving the tab 3254, Which locks the casing 216 to the support arrangement 3200. In use, the locking mechanism 3250 slides along the rail toward the casing 216 once the support arrangement 3200 is aligned therewith. Once the locking mechanism 3250 reaches the casing 216, the tab 3254 engages the casing 216 (e.g. by being inserted in the opening defined in the casing tab 217). The support arrangement 3200 is thus mechanically connected to the casing 216 at this point. The locking mechanism 3250 may be implemented in alternative manners in other implementations, such as for example and without limitations a clamping member, a hook, a magnetic assembly, etc.

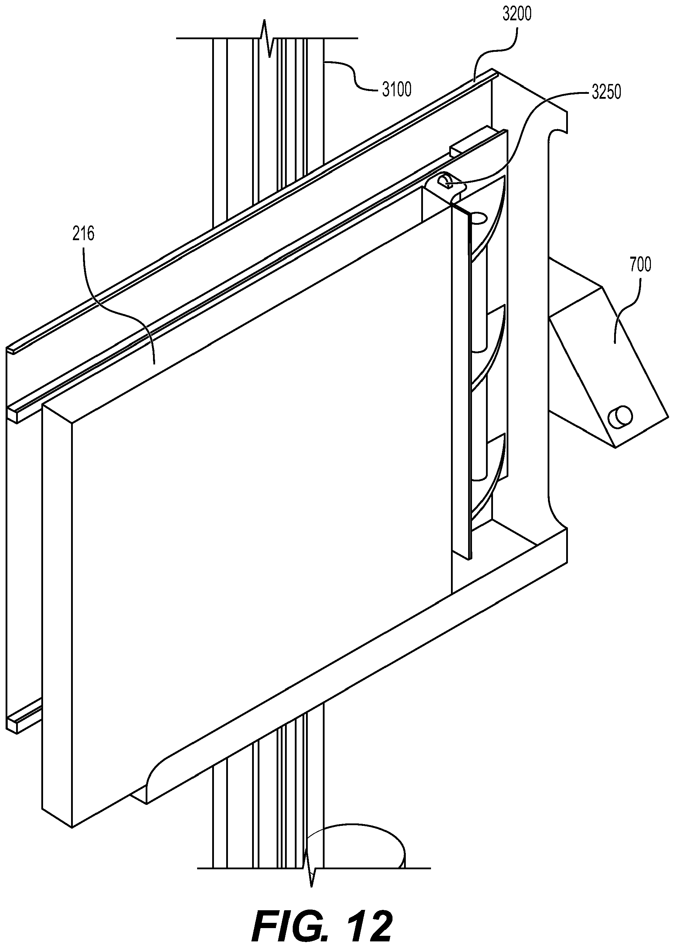

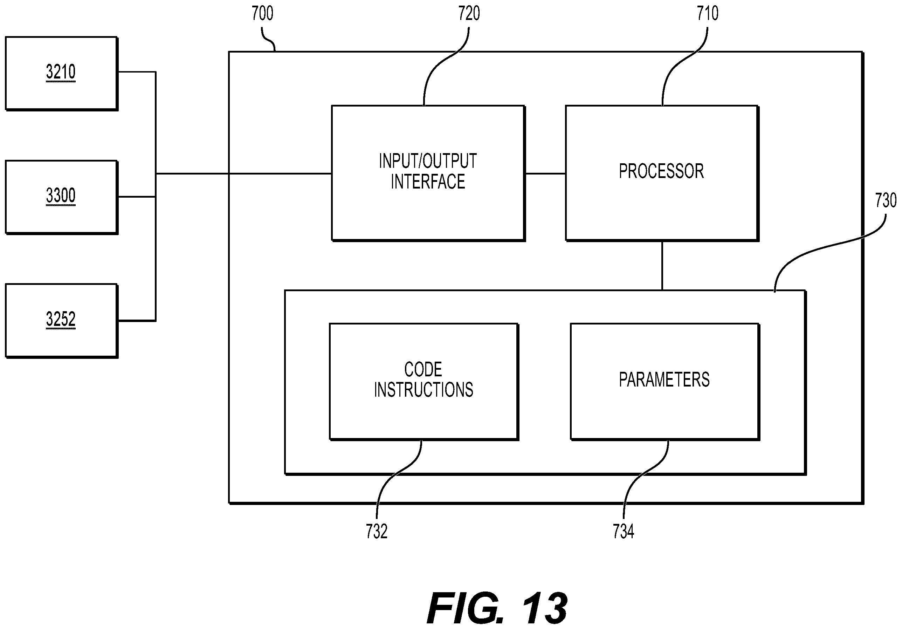

Figure 12 shows the support arrangement 3200 once the casing 216 has been extracted from a corresponding rack system. More specifically, once the support arrangement 3200 is mechanically connected to the casing 216, the position of the locking mechanism 3250 is further adjusted to pull the casing 216 out of the rack system and onto the supporting plate 3220. The casing 216 is thus transferred onto the supporting plate 3220 and the extraction mobile apparatus 3000 may thus carry the casing 216 and the components therein to a desired destination. Disconnection of the electric connections and/or cooling liquid connections may be made before or after transferring the casing 216 onto the supporting plate 3220. Said disconnections may be automatic (e.g. upon the casing 216 being pulled from the rack system 100). The extraction apparatus may for example include a mechanical arm configured to disconnect the components of the rack-mounted assembly 104 from the rack system 100. Alternatively, said components may be manually disconnected by an operator upon extraction of the rack-mounted assembly 104.

In use, the extraction mobile apparatus 3000 navigates along any rack system 100 from which a target rack-mounted assembly 104 is to be extracted. The extraction mobile apparatus 3000 may be, for example and without limitation, be manually operated by a human operator, be autonomous or semi-autonomous. In this implementation, the extraction mobile apparatus 3000 includes a controller 700 that may receive instructions from a human operator, for example via a networking device embedded in the extraction mobile apparatus 3000 and communicably connected with a user device associated with the human operator. The extraction mobile apparatus 3000 may include a dedicated computer system, a chassis controller, and/or sensors to ensure safe displacement thereof along the aisle 1400. The instructions may for example include indication about an identifier of the target rack-mounted assembly 104. The identifier may be a bar code, a QR-code or any other visual or non-visual feature associated with each rack-mounted assembly 104. In some implementations, the extraction mobile apparatus 3000 may include a sensor (e.g. a RGB camera, a RGB-Depth camera, a LIDAR system, a scanning system, etc.) for identifying the target rack-mounted assembly 104 based on the identifier associated therewith.

As such, the extraction mobile apparatus 3000 may be displaced and disposed in a vicinity of the rack system 1100 enclosing the electronic devices 220 to be extracted therefrom in response to receiving instructions from the human operator. The function of this device is to secure the extraction of the "book" component in a cramped environment.

Once the target rack-mounted assembly 104 has been extracted from a corresponding rack system 100, the extraction mobile apparatus 3000 may further move along the aisle 1400 to reach a maintenance area 1600 (see Figure 5) and position the electronic device 220 thereon. In use, the robotic control arm 3055 may also change an orientation of the electronic device 220 between the extraction thereof and disposing the electronic device 220 onto an operation platform of the maintenance area 1600. The operation platform 1060 corresponds to the location on the extraction mobile apparatus 3000 at which an operator would perform maintenance on the electronic device 220. In this implementation, a surface of the operation platform 1060 defines a hole such that residual immersive cooling liquid may drain therein during or before maintenance of the electronic device 220.

Broadly speaking, the extraction mobile apparatus 3000 identifies the target rack-mounted assembly 104, extract the target rack-mounted assembly 104 from the corresponding rack system 100 and may displace the target rack-mounted assembly 104 for maintenance thereof.

As an example, Figure 9 is a schematic block diagram of a controller 700 of the extraction mobile apparatus 3000 according to an embodiment of the present technology. The controller 700 comprises a processor or a plurality of cooperating processors (represented as a processor 710 for simplicity), a memory device or a plurality of memory devices (represented as a memory device 730 for simplicity), and an input/output interface 720 allowing the controller 700 to communicate with other components of the extraction mobile apparatus 3000 and/or other components in remote communication with the extraction mobile apparatus 3000. The processor 710 is operatively connected to the memory device 730 and to the input/output interface 720. The memory device 730 includes a storage for storing parameters 734, including for example and without limitation a pre-defined speed of extraction of the electronic device 220, a maximal translation speed of the locking mechanism 3250 or pre-determined maximum acceleration and maximum speed of the extraction mobile apparatus 3000. The memory device 730 may comprise a non-transitory computer-readable medium for storing code instructions 732 that are executable by the processor 710 to allow the controller 700 to perform the various tasks allocated to the controller 700 for operation of the extraction mobile apparatus 3000.

The controller 700 is operatively connected, via the input/output interface 720, to the mechanical arm 3210, the motor 3300 and the displacing elements 3042. The controller 700 executes the code instructions 732 stored in the memory device 730 to implement the various above-described functions that may be present in a particular embodiment. Figure 7 as illustrated represents a non-limiting embodiment in which the controller 700 orchestrates operations of the extraction mobile apparatus 3000. This particular embodiment is not meant to limit the present disclosure and is provided for illustration purposes.

It will be understood that, although the embodiments presented herein have been described with reference to specific features and structures, various modifications and combinations may be made without departing from the disclosure. The specification and drawings are, accordingly, to be regarded simply as an illustration of the discussed implementations or embodiments and their principles as defined by the appended claims, and are contemplated to cover any and all modifications, variations, combinations or equivalents that fall within the scope of the present disclosure.

## Claims

1. A modular datacenter (100) comprising:
a containment unit (1000) having a first side wall extending along a longitudinal axis of the containment unit (1000) and a second side wall, opposite the first side wall, extending along the longitudinal axis of the containment unit (1000);
a rack system (1100) mounted in the containment unit (1000) and extending along the first side wall, the rack system (1100) being configured to house electronic devices (220) disposed in immersion casings (216) filled with immersion cooling liquid;
and
an extraction mobile apparatus (3000) for performing maintenance on the electronic devices (220), the extraction mobile apparatus (3000) having:
displacing means (3042),
a support arrangement (3200) for receiving at least one of the immersion casings (216), and
a body (3100) extending from the displacing means (3042) to the support arrangement (3200);
the extraction mobile apparatus (3000) being configured to navigate along the rack system (1100).

2. The modular datacenter (100) of claim 1, wherein the extraction mobile apparatus (3000) is further configured to align the support arrangement (3200) longitudinally and vertically in front of the at least one immersion casings (216) when the at least one immersion casings (216) is located in the rack system (1100).

3. The modular datacenter (100) of claim 2, wherein the extraction mobile apparatus (3000) is further configured to extract the at least one immersion casings (216) from the rack system (1100).

4. The modular datacenter (100) of claim 3, wherein is further configured to displace the at least one immersion casing to a maintenance area (1600).

5. The modular datacenter (100) of any one of claims 1 to 4, further comprising a second rack system (1100) mounted in the containment unit (1000) and extending along a second side wall thereof, the second wall being opposed to the first wall, the first and second rack systems (1100) being spaced from one another and defining an aisle there between, the first and second rack systems (1100) being configured to house electronic devices (220) disposed in immersion casings (216) filled with an immersion cooling liquid,
wherein the extraction mobile apparatus (3000) is configured to:
navigate along the aisle, and
extract at least one of the immersion casings (216) from any one of the first and second rack systems (1100).

6. The modular datacenter (100) of any one of claims 1 to 5, further electronic switches electrically coupled to the electronic devices (220), the electronic switches being fixedly attached to a ceiling surface of the containment unit (1000).

7. The modular datacenter (100) of any one of claims 1 to 6, wherein the electronic devices (220) are servers.

8. The modular datacenter (100) of any one of claims 1 to 7, wherein the containment unit (1000) is a shipping container.

9. A method for operating an extraction mobile apparatus (3000) in a modular datacenter, the method comprising:
positioning the extraction mobile apparatus (3000) in front of a rack column of a rack system (1100) within a containment unit (1000) of the modular datacenter, the rack system (1100) being configured to house electronic devices (220) disposed in immersion casings (216) filled with immersion cooling liquid;
positioning a support arrangement (3200) of the extraction mobile apparatus (3000) in front of a given rack shelf of the rack column;
actuating a support arrangement (3200) for extracting at least one of the immersion casings (216) from the rack system (1100); and
actuating displacing means (3042) of the extraction mobile apparatus (3000) to move the extraction mobile apparatus (3000) towards a maintenance area (1600); and
causing the extraction mobile apparatus (3000) to dispose the at least one of the immersion casings (216) in the maintenance area (1600).

10. The method of claim 9, wherein the maintenance area (1600) is defined within the containment unit of the modular datacenter.

11. An extraction mobile apparatus (3000) comprising:
a chassis (3040);
an elongated body (3100) extending substantially vertically from the chassis (3040);
a support arrangement (3200) movably mounted to the elongated body (3100);
displacing means (3042) operably connected to the chassis for displacing the extraction mobile apparatus (3000) along a rack system (1100), the rack system (1100) comprising rack-mounted assemblies; and
a controller communicably connected to the displacing means (3042) and the support arrangement (3200), the controller being configured to:
receive instructions to extract a target rack-mounted assembly;
cause the extraction mobile apparatus (3000) to navigate along the rack system (1100);
cause an adjustment of a height of the support arrangement (3200) relatively to the target rack-mounted assembly to be extracted; and
cause the support arrangement (3200) to extract the target rack-mounted assembly.

12. The extraction mobile apparatus (3000) of claim 11, wherein the displacing means (3042) are operably connected to a ground surface of a containment unit, the rack system (1100) being disposed along a longitudinal side wall of the containment unit.

13. The extraction mobile apparatus (3000) of claim 12, wherein:
the containment unit (1000) further comprises a second rack system (1100) mounted therein and extending along a second side wall thereof, the second wall being opposed to the first wall, the first and second rack systems (1100) being spaced from one another and defining an aisle there between, the first and second rack systems (1100) being configured to house the rack-mounted assemblies,
the elongated body (3100) is pivotably connected to the displacing means (3042), and
the extraction mobile apparatus (3000) is configured to:
navigate along the aisle, and
extract at least one of the immersion casings (216) from any one of the first and second rack systems (1100) by rotating the elongated body (3100).

14. The extraction mobile apparatus of claim 12 or 13, wherein the containment unit is a shipping container.

15. The extraction mobile apparatus of any one of claims 17 to 20, wherein the elongated body (3100) is pivotably connected to the chassis (3040).

## Amended claims

### Amended claims in accordance with Rule 137(2) EPC.

1. An extraction mobile apparatus (3000) for performing maintenance operations on rack-mounted electronic assemblies, comprising:
a chassis (3040);
an elongated body (3100) extending substantially vertically from, and pivotably connected to, the chassis (3040);
a support arrangement (3200) movably mounted to the elongated body (3100) and configured to engage and receive a rack-mounted electronic assembly targeted for maintenance operations;
displacing means (3042) operably connected to the chassis for displacing the extraction mobile apparatus (3000) along a rack system (1100) housing the rack-mounted assemblies;
at least one optical sensor configured to detect identifier codes externally mounted on respective immersion casings (216) individually housing a rack-mounted electronic assembly;
a controller communicably connected to the displacing means (3042) and the support arrangement (3200), the controller being configured to:
receive instructions to extract the target rack-mounted electronic assembly;
cause the extraction mobile apparatus (3000) to navigate along the rack system (1100);
identify the target rack-mounted assembly (104) based on the identifier codes externally mounted on the respective immersion casing (216) of the rack-mounted electronic assemblies,
cause an adjustment of a height of the support arrangement (3200) relative to the identified target rack-mounted electronic assembly to be extracted; and
cause the support arrangement (3200) to extract the identified target rack-mounted electronic assembly from the rack system (1100).

2. The extraction mobile apparatus (3000)of claim 1, wherein the extraction mobile apparatus (3000) is further configured to align the support arrangement (3200) longitudinally and vertically in front of the identified target rack-mounted electronic assembly.

3. The extraction mobile apparatus (3000) of claims 1 to 2, wherein the displacing means (3042) are operably connected to a ground surface of a containment unit, the rack system (1100) being disposed along a longitudinal side wall of the containment unit.

4. The extraction mobile apparatus (3000)of anyone of claims 1 to 3, further configured to transfer the extracted target rack-mounted electronic assembly to a maintenance area (1600).

5. A modular datacenter (100) comprising:
a containment unit (1000) having a first side wall extending along a longitudinal axis of the containment unit (1000) and a second side wall, opposite the first side wall, extending along the longitudinal axis of the containment unit (1000);
a rack system (1100) mounted in the containment unit (1000) and extending along the first side wall, the rack system (1100) configured to house the rack-mounted electronic assemblies disposed in individual immersion casings (216) filled with an immersion cooling liquid, in which each of the immersion casings (216) contain externally mounted identifier codes; and
the extraction mobile apparatus (3000) of anyone of claims 1 to 4 configured to extract the identified target rack-mounted electronic assembly from the rack system (1100).

6. The modular datacenter (100) of claim 5, further comprising a second rack system (1100) mounted in the containment unit (1000) and extending along a second side wall thereof, the second wall being opposed to the first wall, the first and second rack systems (1100) being spaced from one another and defining an aisle there between, the first and second rack systems (1100) being configured to house rack-mounted electronic assemblies disposed in immersion casings (216) filled with an immersion cooling liquid,
wherein the extraction mobile apparatus (3000) is configured to:
navigate along the aisle, and
extract the identified target rack-mounted electronic assembly from any one of the first and second rack systems (1100).

7. The modular datacenter (100) of any one of claims 5 to 6, further comprising electronic switches electrically coupled to the rack-mounted electronic assemblies, the electronic switches being fixedly attached to a ceiling surface of the containment unit (1000).

8. The modular datacenter (100) of any one of claims 5 to 7, wherein the rack-mounted electronic assemblies are servers.

9. The modular datacenter (100) of any one of claims 5 to 8, wherein the containment unit (1000) is a shipping container.

10. A method for operating an extraction mobile apparatus (3000) incorporating at least one optical sensor in a modular datacenter (100), the method comprising:
positioning the extraction mobile apparatus (3000) in front of a rack column of a rack system (1100) within a containment unit (1000) of the modular datacenter, the rack system (1100) being configured to house the rack-mounted electronic assemblies individually disposed in immersion casings (216) filled with immersion cooling liquid, in which each of the immersion casings (216) contain externally mounted identifier codes;
positioning a support arrangement (3200) of the extraction mobile apparatus (3000) in front of a given rack shelf of the rack column containing a rack-mounted electronic assembly targeted for maintenance operations based on the extraction mobile apparatus optical sensor detecting the identifier code of the target rack-mounted electronic assembly;
actuating a support arrangement (3200) for extracting the target rack-mounted electronic assembly from the rack system (1100); and
actuating the displacing means (3042) of the extraction mobile apparatus (3000) to transport and dispose the target rack-mounted electronic assembly to a maintenance area (1600).

11. The method of claim 10, wherein the maintenance area (1600) is defined within the containment unit of the modular datacenter.
